# EUROPEAN PATENT APPLICATION

(11) **EP 4 804 072 A1**
(43) Date of publication of application: **09.09.2026**
(21) Application number: 26157155.8
(22) Date of filing: 09.02.2026
(51) Int. Cl.: G06F 30/20, B61L 19/06, B61L 27/60

(54) **RAILWAY INTERLOCKING DATA VERIFICATION SYSTEM AND METHOD**

(30) Priority: 03.03.2025 GB 202503002
(71) Applicant: Siemens Mobility Limited, London, NW1 2PL (GB)
(72) Inventor: Agbanelo, Chisom, Ashby-de-la-Zouch, LE65 1JD (GB); Dodd, Carl, Chippenham, SN15 1GG (GB); Eaglesham, Shaun, Chippenham, SN15 1GG (GB); Henwood, Stephen, Chippenham, SN15 1GG (GB); Thomas, Mark, Chippenham, SN15 1GG (GB)
(74) Representative: Siemens Patent Attorneys

(57) **Abstract**

A railway interlocking data verification system and method using dynamic simulation and code execution to analyse test cases of interlocking data are described.

## Description

The present invention relates to a railway interlocking data verification system and method of testing railway interlocking data, in particular, a verification system for and method of testing railway interlocking data.

Within the railway industry, the interlocking design process comprises a data design, production check, automatic interlocking data testing, an independent check and finally, principal testing. One key component of this is the automatic interlocking data testing, where interlocking data is tested by running test scripts against a simulation of an interlocking within a simulation environment. This acts as a check of the design process without the need to implement the interlocking design on a live system. Automatic interlocking data testing involves the simulation of an interlocking and running test scripts sequentially against this simulation on a single simulation system. The simulation system itself is of a high fidelity due to the complexity of the interlocking geodata required to execute the test scripts. However, sequential testing may lead to a number of issues, some of which are highlighted below.

Traditionally, the process of simulating interlocking scripts in a test environment has been addressed using two primary methods: static code analysis and single environment simulation. Static code analysis is done using Systra SafeCap, an automated signalling verification system based on formal methods applied to signalling data in its native format. The SafeCap tool takes the interlocking data as an input, creates a mathematical model, defines safety properties, verifies the model against these properties and reports any errors found. For example, the tool interrogates data from a Westlock^{™} interlocking for anything that may violate safety rules. However, the tool does not fully simulate the interlocking test data itself, which may limit the ability to uncover more complex problems with the test data. Whilst not every interlocking data test script may suffer from complex problems, signalling installations involving intricate routes or extensive infrastructure (such as the approach to a mainline terminus station) may give rise to situations where unforeseen issues arise.

A single environment simulation, is, as the name implies, a system where there is a single instance of a simulated interlocking. Whilst this approach provides a test result, the issue is the amount of time required to simulate both the interlocking and the related trackside equipment, both of which are required to generate a test result. Increasing the speed of the testing is difficult, since there is no possibility to skip simulating all of the relevant equipment. Since the interlocking being simulated is safety-critical, the testing must replicate real-life scenarios as closely as possible.

In addition to the data, time and resource constraints mentioned above, testing time may also be increased as a result of any re-work and re-testing of the interlocking test data that may be required. Often issues are not picked up until test results are viewed as a test report, meaning that it is necessary to fix such issues and re-run the testing again to determine whether or not a solution has been found. Hence it is desirable to have a testing solution that is able not just to decrease the overall testing time, including any potential re-working or changes, but also one that is able to identify complex problems with interlocking data, achieving both whilst maintaining the integrity of the verification process of safety-critical data. There is a need, therefore, to be able to verify interlocking data both quickly and with confidence.

The present invention aim to address these issues by providing, in a first embodiment, railway interlocking data verification system, comprising: a remote desktop client; a first, cloud-based, virtual machine hosting a virtual railway interlocking design environment and comprising: an interlocking test tool (ITT) server; and a task distributor in communication with both the remote desktop client and the ITT server; and at least two cloud-based, virtual ITT worker machines, each in communication with the ITT server and configured to execute test cases on real interlocking data running on a simulation interlocking within the virtual railway interlocking design environment when selected to do so by the task distributor.

Using multiple virtual ITT worker machines in a cloud environment to simulate a real-life interlocking system in order to verify test cases of interlocking data removes the issues surrounding sequential verification and static code analysis by enabling a multi-run environment limited only by the number of virtual ITT worker machines spun up at any one time.

Preferably, the at least two virtual ITT worker machines are further configured to execute test cases of interlocking data as simulations simultaneously with, and independently of, each other.

Preferably, the ITT server is configured to: instruct the at least two virtual ITT worker machines to execute test cases when selected by the task distributor; receive a set of test results generated by executing the test cases from the at least two virtual ITT worker machines; and generate a test report for export to the task distributor based on the set of test results. Preferably, the task distributor is provided with a single test script comprising a plurality of test cases, and wherein the ITT server is further configured to split the test script into the individual test cases for distribution one at a time to the virtual ITT worker machines.

Preferably, the at least two cloud-based virtual ITT worker machines are configured to run a simulation environment comprising a central interlocking processor simulator, a control system simulator, a trackside and adjacent interlocking simulator and an ITT worker application, wherein the central interlocking processor is configured in the simulation to run the interlocking data being tested.

One of the virtual ITT worker machines may be installed on the ITT server.

In a second embodiment, the present invention also provides a method of verifying railway interlocking data, comprising: launching a first cloud-based virtual machine from a remote desktop client, wherein the virtual machine comprises an interlocking test tool (ITT) server and a task distributor, wherein the task distributor is in communication with both the remote desktop client and the ITT server; launching at least two cloud-based, virtual ITT worker machines, each in communication with the ITT server and configured to execute test cases on real interlocking data running on a simulation interlocking within a virtual railway interlocking design environment when selected to do so by the task distributor; selecting at least two virtual ITT worker machines; distributing a test case of interlocking data to each selected virtual ITT worker machine; at each selected virtual ITT worker machine: executing the distributed test case of interlocking data as a simulation within the virtual railway interlocking design environment; generating a set of test results on the basis of the executed test case; and sending the set of test results to the ITT server; receiving the set of test results at the ITT server and generating a test report for export to the task distributor based on the set of test results; and exporting the test report to the task distributor to display in the remote desktop client to a user.

Preferably, the at least two virtual ITT worker machines are further configured to execute test cases of interlocking data as simulations simultaneously with, and independently of, each other.

Preferably, the task distributor is provided with a single test script comprising a plurality of test cases, and the step of distributing the test cases further comprises splitting the test script into the individual test cases for distribution one at a time to the virtual ITT worker machines.

Preferably, the method further comprises, following the launching of the at least two virtual ITT worker machines, loading, into the task distributor, a configuration file containing settings enabling the execution of test cases on real interlocking data running on a simulation interlocking across selected virtual ITT worker machines and the IP addresses of each launched virtual ITT worker machine.

The method may further comprise collating test results from each selected virtual ITT worker machine at the ITT server prior to generating the test report for export to the task distributor.

The selecting of at least one virtual ITT worker machine may be done by a user via the remote desktop client.

If a selected virtual ITT worker machine fails to complete the execution of a test case, the method may further comprise checking the test case for errors. Preferably, the at least two virtual ITT worker machines create a multi-run environment executing test cases on real interlocking data running on a simulation interlocking in parallel.

Preferably, the step of executing the distributed test cases comprises: running a simulation environment comprising a central interlocking processor simulator, a control system simulator, a trackside and adjacent interlocking simulator and ITT worker application, wherein the central interlocking processor is configured in the simulation to run the interlocking data being tested.

The embodiments of the present invention will now be described by way of example only, and with reference to the accompanying drawings, in which:
Figure 1 is a schematic system diagram of a railway interlocking data verification system in accordance with an embodiment of the present invention; and
Figure 2 is a schematic flow chart outlining a method of testing railway interlocking data in accordance with an embodiment of the present invention.

The embodiments of the present invention take an approach that enables the creation of a Multi-Run Environment (MRE) simulation based on the interlocking data in a test script itself. This is done using a railway interlocking data verification system, which comprises a remote desktop client and a first, cloud-based, virtual machine hosting a virtual railway interlocking design environment. Moving the simulation to virtual machines hosted within a cloud environment removes issues associated with computing resources in a conventional desktop computer. The first, virtual, machine, comprises an interlocking test tool (ITT) server and a task distributor. The ITT server and task distributor are in communication with both the remote desktop client and the ITT workers, which enables a user to select tasks for execution via the ITT server. To allow test cases to be executed on real interlocking data running on a simulation interlocking, at least two cloud-based, virtual ITT worker machines are launched on command from the user, each of which is in communication with the ITT server. Each virtual ITT worker is configured to execute test cases on real interlocking data running on a simulation interlocking within the virtual railway interlocking design environment when selected to do so by the task distributor. As part of the MRE, the at least two ITT worker machines are preferably further configured to execute test cases on real interlocking data running on a simulation interlocking simultaneously with, and independently of, each other. These, and other details of the embodiments of the present invention, are described in further detail below.

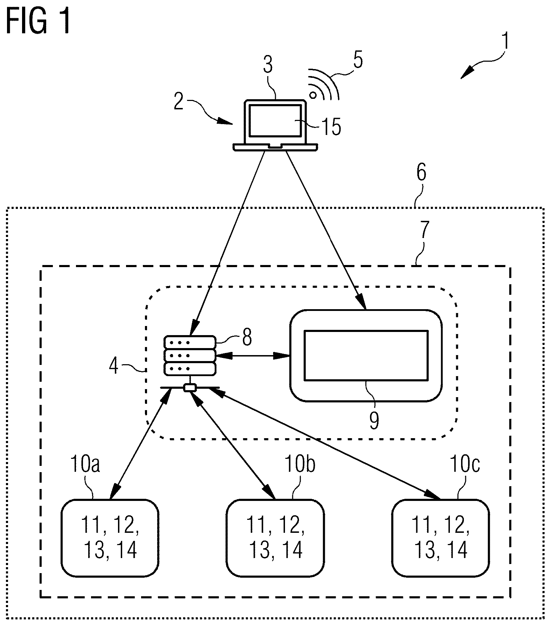

Figure 1 is a schematic system diagram of a railway interlocking data verification system in accordance with an embodiment of the present invention. The railway interlocking verification system 1 comprises a remote desktop client 2 hosted, in this example, on a conventional desktop computer 3. To enable the remote desktop client 2 to be in communication with a first, cloud-based virtual machine 4, the conventional desktop computer 3 is linked to a communications network 5. The first, cloud-based virtual machine 4 sits in a cloud environment 6, which may be any suitable cloud or distributed computing infrastructure. The first, cloud-based virtual machine is within a virtual railway interlocking design environment 7. This comprises an Interlocking Test Tool (ITT) server 8 and a task distributor 9, which is in communication with both the remote desktop client 2 (via the communications network 5) and the ITT server 8 (by virtue of being part of the same cloud-based virtual machine). The task distributor is provided with a single test script comprising a plurality of test cases. In addition, the railway interlocking data verification system 1 has at least two cloud-based virtual ITT worker machines 10a...10*n.* In this example, three virtual ITT worker machines 10a, 10b, 10c are shown, however, the railway interlocking data verification system 1 may have as many virtual ITT worker machines 10a...10*n* as required to enable an MRE to be set up. One of the virtual ITT worker machines 10a...10*n* may be installed on the ITT server 8 itself. The ITT server 8 is further configured to split the test script into the individual test cases for distribution one at a time to the virtual ITT worker machines 10a...*10n.* Each of the virtual ITT worker machines 10a, 10b, 10c are in communication with the ITT server 8 and are configured to execute setup scripts and test cases of interlocking data as simulations within the virtual railway interlocking design environment 7 when selected to do so by the task distributor 9. This is achieved by each of the virtual ITT worker machines 10a, 10b, 10c being configured to run a simulation environment comprising a central interlocking processor simulator 11, a control system simulator 12, a trackside and adjacent interlocking simulator 13 and an ITT worker application 14, where the central interlocking processor 11 is configured in the simulation to run the interlocking data being tested. The ITT worker application 14 is configured to run the test case and carry out the required test. As part of an MRE, the virtual ITT worker machines 10a, 10b, 10c, are preferably further configured to execute test cases of interlocking data as simulations simultaneously with, and independently of, each other. This enables the creation of an MRE where the virtual ITT worker machines 10a, 10b, 10c, execute test cases of interlocking data in parallel.

The various features of the railway interlocking data verification system 1 are under the control of a user via a user interface 15 provided as part of the remote desktop client 2. The user interface 15 allows a user to directly select functionality within the task distributor 10, including the selection of virtual ITT worker machines 10a...10*n* and the required interlocking test data cases for testing. In order to provide test results following the execution of the selected test cases of interlocking data, the ITT server 8 is configured to carry out several tasks, including:
- instruct the at least two virtual ITT worker machines 10a...10*n* to execute test cases when selected by the task distributor 9;
- receive a set of test results generated by executing the test cases from the at least two virtual ITT worker machines 10a...10*n*; and
- generate a test report for export to the task distributor 9 based on the set of test results.

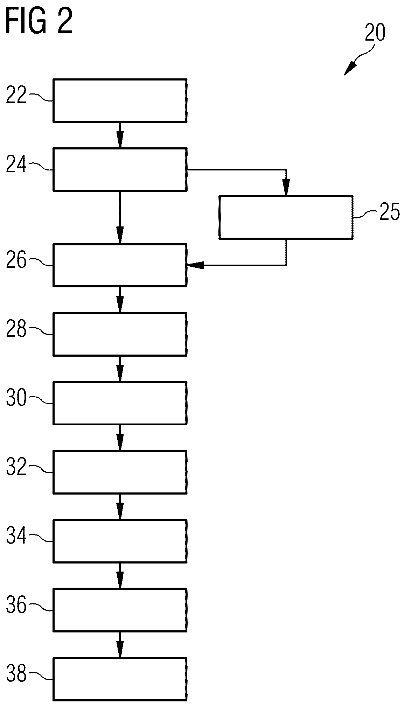

Figure 2 is a schematic flow chart outlining a method of testing railway interlocking data in accordance with an embodiment of the present invention. The method 20 begins, at step 22, with launching a first cloud-based virtual machine 4 from a remote desktop client 2, wherein the virtual machine 4 comprises an interlocking test tool (ITT) server 8 and a task distributor 9, wherein the task distributor 9 is in communication with both the remote desktop client 2 and the ITT server 8. Next, at step 24, at least two cloud-based, virtual ITT worker machines *10a...10n* are launched. Each of these is in communication with the ITT server 8 and configured to execute test cases of interlocking data within a virtual railway interlocking design simulation environment 8 when selected to do so by the task distributor 9. To carry out the interlocking data test process, at step 26, at least two virtual ITT worker machines 10a...10*n* are selected, so that, at step 28, a test case of interlocking data can be distributed to each selected virtual ITT worker machine 10a...10*n.* The task distributor 9 is provided with a single test script comprising a plurality of test cases, and the step of distributing the test cases further comprises splitting the test script into the individual test cases for distribution one at a time to the virtual ITT worker machines 10a...10*n*.The selection of virtual ITT worker machines 10a...10*n* may be done by the user via the remote desktop client. Alternatively, the selection may be automatic based purely on the availability of a virtual ITT worker machine 10a...10*n* and the number of test cases of interlocking data that require testing and verification. Step 30 takes place across the selected virtual ITT worker machines *10a...10n,* as at each selected virtual ITT worker machine 11a...11*n,* the distributed test case of interlocking data is executed as a simulation within the virtual railway interlocking design environment 7. Then, each selected virtual ITT worker machine 10a...10*n* generates a set of test results on the basis of the executed test case at step 32. Once this is complete, at step 34, the set of test results are sent to the ITT server 8. When results are received at the ITT server 8 at step 36, a test report is generated for export to the task distributor 9 based on the set of test results. Finally, at step 38, the ITT server 8 exports the test report to the task distributor 10 for display at the remote desktop client 2 to a user.

As an intervening step, at step 25 a configuration file containing settings enabling the execution of test cases of interlocking data across selected virtual ITT worker machines 10a...10*n* and the IP addresses of each launched virtual ITT worker machine 10a...10*n* may be loaded into the task distributor 9. This configuration file may be loaded into the task distributor 9 by a user. Alternatively, a configuration file may be generated automatically at the launching of the virtual ITT worker machines 10a...10*n* by the ITT server 8.

In the embodiment outlined above, test reports relating to the execution of individual test cases of interlocking data may be generated on receipt of each set of test results. It may be preferable, however, to collate tests results from each selected virtual ITT worker machine 10a...10*n* at the ITT server 8 prior to generating the test report for export to the task distributor 9. Which ITT worker 10a...10*n* executed which test case however is irrelevant for the report generation.

One advantage of the railway interlocking data verification system 1 shown in Figure 1 above and the method outlined in Figure 2 above is that, depending on virtual ITT worker machine 10a...10n availability, additional virtual ITT worker machines 10a...10*n* may be spun up from the remote desktop client 2 when required. If a selected virtual ITT worker *10a...10n* machine fails to complete the execution of a test case the test case is checked for errors. This is one advantage that such an MRE has over conventional SREs in interlocking verification, since each virtual ITT worker machine 10a...10*n* is, as discussed above, preferably configured to execute test cases on real interlocking data running on a simulation interlocking simultaneously with, and independently of, each other. The use of multiple virtual ITT worker machines *10a...10n* in general enables the creation of a multi-run environment executing test cases on real interlocking data running on a simulation interlocking in parallel. This is one of the ways in which the embodiments of the present invention reduce processing time. Ensuring that test cases of interlocking data can be run simultaneously reduces this processing time yet further. Using a virtual cloud-based approach is also beneficial as the effective processing resources are not limited by the hardware of the conventional desktop computer 3 used to host the remote desktop client 2. The railway interlocking data verification system 1 is also a dynamic testing system, in contrast to the static code analysis carried out in existing systems. In particular, a dynamic system is based on the execution of the data under test, whereas a static code analysis system analyses the code without execution in a simulation environment. The use of such dynamic testing within a verification system provides an improved evaluation of the behaviour of the interlocking under various operating conditions, and so may highlight issues, such as timing or implementation problems, which are missed or not appreciated by static code analysis.

These and other embodiments and advantages of the invention will be apparent from the scope of the appended claims.

## Claims

1. Railway interlocking data verification system, comprising:
a remote desktop client;
a first, cloud-based, virtual machine hosting a virtual railway interlocking design environment and comprising:
an interlocking test tool (ITT) server; and
a task distributor in communication with both the remote desktop client and the ITT server;
and
at least two cloud-based, virtual ITT worker machines, each in communication with the ITT server and configured to execute test cases of interlocking data as simulations within the virtual railway interlocking design environment when selected to do so by the task distributor.

2. Railway interlocking data verification system as claimed in claim 1, wherein the at least two virtual ITT worker machines are further configured to execute test cases of interlocking data as simulations simultaneously with, and independently of, each other.

3. Railway interlocking data verification system as claimed in claim 1 or 2, wherein the task distributor is provided with a single test script comprising a plurality of test cases, and wherein the ITT server is further configured to split the test script into the individual test cases for distribution one at a time to the virtual ITT worker machines.

4. Railway interlocking data verification system as claimed in claim 1, 2 or 3, wherein the ITT server is configured to:
instruct the at least two virtual ITT worker machines to execute test cases when selected by the task distributor;
receive a set of test results generated by executing the test cases from the at least two virtual ITT worker machines; and
generate a test report for export to the task distributor based on the set of test results.

5. Railway interlocking data verification system as claimed in any of claims 1 to 4, wherein the at least two cloud-based virtual ITT worker machines are configured to run a simulation environment comprising a central interlocking processor simulator, a control system simulator, a trackside and adjacent interlocking simulator and an ITT worker application, wherein the central interlocking processor is configured in the simulation to run the interlocking data being tested.

6. Railway interlocking data verification system as claimed in any of claims 1 to 5, wherein one of the virtual ITT worker machines is installed on the ITT server.

7. A method of verifying railway interlocking data, comprising:
launching a first cloud-based virtual machine from a remote desktop client, wherein the virtual machine comprises an interlocking test tool (ITT) server and a task distributor, wherein the task distributor is in communication with both the remote desktop client and the ITT server;
launching at least two cloud-based, virtual ITT worker machines, each in communication with the ITT server and configured to execute test cases of interlocking data as simulations within a virtual railway interlocking design environment when selected to do so by the task distributor;
selecting at least two virtual ITT worker machines;
distributing a test case of interlocking data to each selected virtual ITT worker machine;
at each selected virtual ITT worker machine:
executing the distributed test case of interlocking data as a simulation within the virtual railway interlocking design environment;
generating a set of test results on the basis of the executed test case; and
sending the set of test results to the ITT server;
receiving the set of test results at the ITT server and generating a test report for export to the task distributor based on the set of test results; and
exporting the test report to the task distributor to display in the remote desktop client to a user.

8. Method as claimed in claim 7, wherein the at least two virtual ITT worker machines are further configured to execute test cases of interlocking data as simulations simultaneously with, and independently of, each other.

9. Method as claimed in claim 7 or 8, wherein the task distributor is provided with a single test script comprising a plurality of test cases, and the step of distributing the test cases further comprises splitting the test script into the individual test cases for distribution one at a time to the virtual ITT worker machines.

10. Method as claimed in claim 7, 8 or 9, further comprising:
following the launching of the at least two virtual ITT worker machines, loading, into the task distributor, a configuration file containing settings enabling the execution of test cases of interlocking data across selected virtual ITT worker machines and the IP addresses of each launched virtual ITT worker machine.

11. Method as claimed in any of claims 7 to 10, further comprising collating test results from each selected virtual ITT worker machine at the ITT server prior to generating the test report for export to the task distributor.

12. Method as claimed in any of claims 7 to 11, wherein the selecting of at least one virtual ITT worker machine is done by a user via the remote desktop client.

13. Method as claimed in any of claims 7 to 12, wherein if a selected virtual ITT worker machine fails to complete the execution of a test case, the method further checking the test case for errors.

14. Method according to any of claims 7 to 13, wherein the at least two virtual ITT worker machines create a multi-run environment executing test cases of interlocking data in parallel.

15. Method according to any of claims 7 to 14, wherein the step of executing the distributed test cases comprises:
running a simulation environment comprising a central interlocking processor simulator, a control system simulator, a trackside and adjacent interlocking simulator and an ITT worker application, wherein the central interlocking processor is configured in the simulation to run the interlocking data being tested.
